# EUROPÄISCHE PATENTSCHRIFT

(11) **EP 2 613 220 B1**
(45) Veröffentlichungstag und Bekanntmachung des Hinweises auf die Patenterteilung: **18.07.2018**
(21) Anmeldenummer: 12198625.1
(22) Anmeldetag: 20.12.2012
(51) Int. Cl.: G06F 1/18, H01R 13/44, H05K 5/02

(54) **Gehäuse für ein Computersystem sowie Computersystem mit einem derartigen Gehäuse**
Housing for a computer system and computer system with such a housing
Boîtier pour système informatique et système informatique équipé d'un tel boîtier

(30) Priorität: 04.01.2012 DE 102012100056
(43) Veröffentlichungstag der Anmeldung: 10.07.2013
(73) Patentinhaber: Fujitsu Technology Solutions Intellectual Property GmbH, 80807 München (DE)
(72) Erfinder: Neukam, Wilhelm, 86399 Bobingen (DE)
(74) Vertreter: Epping - Hermann - Fischer

(56) Entgegenhaltungen:
- EP-A1- 0 176 676
- US-A1- 2011 155 447
- US-B1- 6 902 421
- US-B1- 7 207 812

## Beschreibung

Die Erfindung betrifft ein Gehäuse für ein Computersystem, wobei das Gehäuse zumindest an einer ersten Gehäusewandung zum Zugang in das Gehäuse geöffnet werden kann und an einer zweiten Gehäusewandung eine Öffnung für einen externen Anschlussstecker angeordnet ist und wobei das Gehäuse eine Verriegelungsvorrichtung zum Verriegeln der ersten Gehäusewandung gegen ein Öffnen des Gehäuses aufweist, wobei die Verriegelungsvorrichtung an der Öffnung für einen externen Anschlussstecker angeordnet und über einen externen Anschlussstecker derart bedienbar ist, dass die erste Gehäusewandung verriegelt ist, wenn ein externer Anschlussstecker in die Öffnung eingeführt ist, und die erste Gehäusewandung entriegelt ist, wenn kein externer Anschlussstecker in die Öffnung eingeführt ist.

Ferner betrifft die Erfindung ein Computersystem mit einem derartigen Gehäuse.

Computersysteme weisen elektronische Komponenten auf, welche stromführend sind und/oder an denen eine elektrische Spannung anliegt. Beim Öffnen eines Gehäuses eines Computersystems besteht bei unsachgemäßer Bedienung die Gefahr eines elektrischen Schlags (so genannte Energiegefahr oder Gefahr eines Elektrounfalls). Eine unsachgemäße Bedienung ist beispielsweise dadurch gegeben, dass das Computersystem bei geöffnetem Gehäuse über einen externen Anschlussstecker nach außen mit einer Strom- oder Spannungsquelle verbunden ist. Dies kann beispielsweise über eine Stromversorgungseinheit (wie ein Netzteil) erfolgen, welche mit dem Stromversorgungsnetz verbunden ist.

Insbesondere bei Computersystemen, bei denen die Stromversorgung zur Umwandlung der netzseitigen Wechselspannung in eine Versorgungsspannung innerhalb des Gehäuses des Computersystems angeordnet ist, liegen an elektronischen Komponenten im Gehäuse hohe (Eingangs-) Spannungen an.

Aus der Druckschrift US 2011/0155447 A1 ist bereits ein Gehäuse der eingangs genannten Art bekannt, wobei ein externer Anschlussstecker durch eine Öffnung an einem laschenartig angeformten äußeren Teil einer zu öffnenden Gehäusewandung hindurchtauchen kann, sodass bei gestecktem Anschlussstecker die Gehäusewandung gegen eine Relativbewegung bezüglich des Gehäuses blockiert ist und nicht geöffnet werden kann. Diese Lösung hat jedoch u.a. den Nachteil, dass eine mechanische Verformung des laschenartig angeformten Teils zu einer Fehlfunktion oder zum Ausfall dieser Funktionalität führen kann.

Es ist Aufgabe der Erfindung, eine verbesserte Verriegelungsvorrichtung aufzuzeigen und ein Computersystem dadurch sicherer gegen unsachgemäße Bedienung zu machen, sodass die Energiegefahr für einen Benutzer erheblich reduziert bzw. unterbunden wird.

Die Aufgabe wird durch ein Gehäuse gemäß Anspruch 1 gelöst. Ein derartiges Gehäuse kann an der ersten Gehäusewandung nur geöffnet werden, wenn kein externer Anschlussstecker in die Öffnung an der zweiten Gehäusewandung eingeführt ist. Auf diese Weise wird ein Zugang zum Gehäuseinnenraum verhindert, wenn ein externer Anschlussstecker gesteckt ist und beispielsweise elektronische Komponenten im Gehäuseinnenraum von außen mit elektrischer Energie versorgt. Erst wenn der externe Anschlussstecker gezogen ist, gibt die Verriegelungsvorrichtung die erste Gehäusewandung frei, sodass diese geöffnet werden kann. Auf diese Weise wird die Gefahr eines elektrischen Schlags durch stromführende beziehungsweise unter elektrischer Spannung stehende Komponenten im Gehäuseinnenraum erheblich reduziert beziehungsweise verhindert.

Die Verriegelungsvorrichtung ist derart an der Öffnung für den externen Anschlussstecker angeordnet und zugleich mit der ersten Gehäusewandung gekoppelt, dass die Verriegelungsvorrichtung die erste Gehäusewandung verriegelt, solange ein externer Anschlussstecker in die Öffnung eintaucht.

Die Begriffe "erste" und "zweite" Gehäusewandung beschreiben unterschiedliche Gehäusewandungen an einem Gehäuse. Das bedeutet, dass die erste Gehäusewandung sich beispielsweise über eine erste Fläche erstreckt, wobei sich die zweite Gehäusewandung über eine zweite Fläche erstreckt. Die beiden Flächen sind nicht parallel zueinander ausgebildet. Im einfachsten Fall kann die erste Gehäusewandung nahezu senkrecht zur zweiten Gehäusewandung ausgeführt sein.

Beispielsweise kann die erste Gehäusewandung eine Seitenwand eines Gehäuses und die zweite Gehäusewandung eine Rückwand eines Gehäuses sein.

Ein Gehäuse der vorliegenden Art vermeidet somit eine unsachgemäße Bedienung, welche darin bestehen kann, dass ein Computersystem, welches von dem Gehäuse beherbergt wird, mit dem Stromversorgungsnetz verbunden wird, obwohl das Gehäuse geöffnet ist und für einen Benutzer elektronische Komponenten zugänglich sind, welche Strom führen und/oder an denen eine elektrische Spannung anliegt. Somit wird die Gefahr eines elektrischen Schlags durch das vorgenannte Gehäuse erheblich reduziert oder sogar unterbunden.

Insbesondere ist ein derartiges Gehäuse für Computersysteme vorteilhaft, bei denen die Stromversorgungseinheit, das heißt das Netzteil, in das Gehäuse integriert ist. Die Stromversorgungseinheit kann dabei fest in das Gehäuse integriert sein, sodass diese nicht ausbaubar ist.

Es ist denkbar, dass der Riegel selbst mit einem externen Anschlussstecker mechanisch zusammenwirkt. Alternativ ist denkbar, zumindest ein Kopplungselement zwischen einem externen Anschlussstecker und dem Riegel zur Zwangskoppelung eines externen Anschlusssteckers mit dem Riegel vorzusehen.

In einer Ausführungsform ist der Riegel über ein flexibles Element gefedert gelagert. Der Riegel ist bei Entspannung des flexiblen Elements in der ersten Position und kann entgegen einer Kraft des flexiblen Elements von der ersten Position in die zweite Position gebracht werden. Das flexible Element kann jegliche Art von Federung sein. Der Vorteil der Kopplung des Riegels mit einem flexiblen Element besteht darin, dass der Riegel automatisch in die erste Position bewegt und dort gehalten wird, wenn ein externer Anschlussstecker aus der Öffnung des Gehäuses herausgezogen ist. Nur bei mechanischem Zusammenwirken eines externen Anschlusssteckers mit der Verriegelungsvorrichtung, einer Kopplungsvorrichtung beziehungsweise unmittelbar mit dem Riegel wird der Riegel entgegen der Kraft des flexiblen Elements in die zweite Position gebracht und dort gehalten.

Sobald ein externer Anschlussstecker aus der Öffnung gezogen wird, wird der Riegel durch die Kraft des flexiblen Elements von der zweiten Position zurück in die erste Position gezwungen. Auf diese Weise wird sichergestellt, dass das Gehäuse automatisch entriegelt ist, wenn der externe Anschlussstecker gezogen ist. Ein zusätzlicher Bedienvorgang zum Entriegeln ist nicht notwendig.

In einer Ausführungsform ist die Bewegungsrichtung des Riegels von der ersten Position in die zweite Position eine Drehbewegung. Das bedeutet, dass der Riegel zwischen der ersten und der zweiten Position relativ zu einer Steckbewegung des externen Anschlusssteckers schwenkbar ist.

In einer alternativen Ausführungsform ist die Bewegungsrichtung des Riegels linear schräg zur Bewegungsrichtung eines externen Anschlusssteckers, der in die Öffnung eingeführt wird. "Linear schräg" bedeutet hier, dass die Bewegungsrichtung des Riegels nicht parallel ist zur Bewegungsrichtung des externen Anschlusssteckers. Insbesondere kann die Bewegungsrichtung des Riegels nahezu senkrecht zur Bewegungsrichtung eines externen Anschlusssteckers sein. In beiden Ausführungsformen mit alternativen Bewegungen des Riegels wird die Steckbewegung eines externen Anschlusssteckers umgesetzt in eine Bedienbewegung des Riegels zum Ver- beziehungsweise Entriegeln der ersten Gehäusewandung.

Vorteilhaft ist ein Computersystem mit einem Gehäuse der beschriebenen Art ausgebildet, wobei im Gehäuse zumindest ein Systemboard des Computersystems sowie hinter der Öffnung an der zweiten Gehäusewandung des Gehäuses ein Stromversorgungsanschluss zum elektrischen Zusammenwirken mit einem externen Anschlussstecker angeordnet ist.

In einer Ausführungsform umfasst das Computersystem eine Stromversorgungseinheit, das heißt ein Netzteil, welche im Gehäuse des Computersystems, beispielsweise auf dem Systemboard, angeordnet ist. Die Stromversorgungseinheit kann dabei fest im Gehäuse des Computersystems montiert sein, sodass die Stromversorgungseinheit nicht ausbaubar ist. Zur Versorgung des Computersystems mit elektrischer Energie kann ein externer Anschlussstecker durch die Öffnung des Gehäuses eingeführt und mit dem Stromversorgungsanschluss im Gehäuse verbunden werden, sodass dem Computersystem von außen elektrische Energie zugeführt werden kann.

Insbesondere im Fall einer im Gehäuse integrierten Stromversorgungseinheit kann dem Computersystem von außen elektrische Wechselspannung des Stromversorgungsnetzes, in der Regel 230 V Wechselspannung, zugeführt werden. Gerade im letztgenannten Fall ist es vorteilhaft, das Gehäuse des Computersystems an der ersten Gehäusewandung nur dann öffnen zu können, wenn der externe Anschlussstecker des Stromversorgungsnetzes vom Gehäuse abgezogen ist. Somit wird die Gefahr eines elektrischen Schlags für ein Bedien- oder Servicepersonal des Computersystems erheblich reduziert.

In unterschiedlichen Ausführungsformen ist das Computersystem ein Thin Client, ein All-in-one-PC oder ein Mini-PC.

Weitere vorteilhafte Ausführungsformen werden in den Unteransprüchen sowie in der nachfolgenden Figurenbeschreibung offenbart. Der Gegenstand wird anhand mehrerer Zeichnungen erläutert.

Es zeigen:
- Figur 1: eine perspektivische Darstellung einer Anordnung mit einem externen Anschlussstecker und einem Teil eines Gehäuses eines Computersystems in einem ersten Zustand,
- Figur 2: die Anordnung gemäß Figur 1 in einem zweiten Zustand,
- Figur 3: eine Schnittdarstellung einer Anordnung eines externen Anschlusssteckers mit einem Teil eines Gehäuses,
- Figur 4A: eine Schnittdarstellung einer Anordnung eines Anschlusssteckers mit einem Teil eines Gehäuses in einer alternativen Ausführungsform in einem ersten Zustand,
- Figur 4B: die Anordnung gemäß Figur 4A in einem zweiten Zustand und
- Figur 4C: eine alternative Ausführungsform von Komponenten eines Gehäuses.

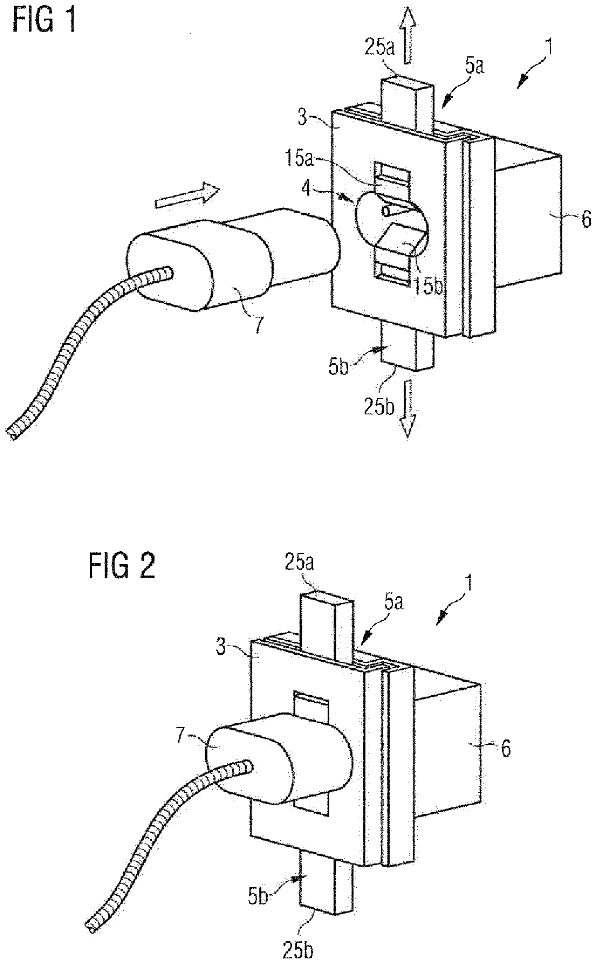

Figur 1 zeigt eine Anordnung mit einem externen Anschlussstecker 7 und einem Teil eines Gehäuses 1. In der Darstellung gemäß Figur 1 ist der externe Anschlussstecker 7 nicht mit dem Gehäuse 1 verbunden.

Das Gehäuse 1 weist eine Gehäuseseitenwand 3 mit einer Öffnung 4 für den externen Anschlussstecker 7 auf. Im Gehäuseinnenraum hinter der Öffnung 4 ist ein Stromversorgungsanschluss 6 zum elektrischen Zusammenwirken mit dem Anschlussstecker 7 eingerichtet. Das Gehäuse 1 kann beispielsweise ein Gehäuse eines Computersystems (z.B. Thin Client, All-in-one-PC oder Mini-PC) bilden, welches über den externen Anschlussstecker 7 mit elektrischer Energie versorgt wird.

Weiterhin umfasst das Gehäuse 1 eine Verriegelungsvorrichtung mit zwei Riegeln 5a und 5b. Die Riegel 5a und 5b sind derart angeordnet, dass sie nahezu senkrecht zu einer Bewegungsrichtung des externen Anschlusssteckers 7 (siehe Pfeile) bewegbar sind. Insbesondere ist der Riegel 5a von einer in Figur 1 dargestellten ersten Position in Pfeilrichtung nach oben in eine zweite Position bewegbar. Der Riegel 5b ist von der in Figur 1 dargestellten ersten Position in Pfeilrichtung nach unten in eine zweite Position bewegbar. Beide Riegel 5a und 5b weisen jeweils ein erstes Ende 15a und 15b auf, welches in der ersten Position gemäß Figur 1 in die Öffnung 4 für den externen Anschlussstecker hineinragt. Das heißt, die ersten Enden 15a und 15b tauchen in die Öffnung 4 derart ein, dass sie mechanisch mit dem Anschlussstecker 7 zusammenwirken können. Zweite Enden 25a und 25b der Riegel 5a und 5b ragen über die Gehäuseseitenwand 3 hinaus und dienen zum Verriegeln von weiteren Gehäusewänden, wie nachfolgend erläutert wird.

Die ersten Enden 15a und 15b der Riegel 5a und 5b sind im Ausführungsbeispiel gemäß Figur 1 mit Anlaufschrägen vorgesehen, welche bei Kontakt mit dem Anschlussstecker 7 beide Riegel 5a und 5b in ihrer jeweiligen Bewegungsrichtung (siehe Pfeilrichtungen) in die zweite Position zwingen. Das bedeutet, dass bei Einstecken des Anschlusssteckers 7 in die Öffnung 4 an der Gehäuseseitenwand 3 die Riegel 5a und 5b über die Anlaufschrägen 15a und 15b jeweils nach oben beziehungsweise nach unten gedrückt werden.

Figur 2 zeigt die Anordnung gemäß Figur 1, wobei der Anschlussstecker 7 in die Öffnung 4 (siehe Figur 1) eingesteckt ist und beide Riegel 5a und 5b gemäß der erläuterten Art bedient wurden. Das bedeutet, die Riegel 5a und 5b sind nun in einer zweiten Position befindlich, welche sich von der Position gemäß Figur 1 unterscheidet. Insbesondere sind die zweiten Enden 25a und 25b der Riegel 5a und 5b nach oben beziehungsweise nach unten bewegt worden. In der in Figur 2 dargestellten Position dienen die Enden 25a und 25b zum Verriegeln von Gehäuseverkleidungen beziehungsweise Gehäusewänden, wie nachfolgend erläutert wird.

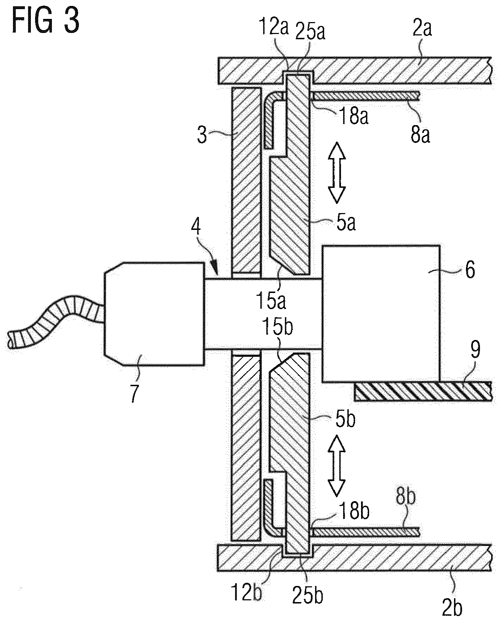

Figur 3 zeigt eine Schnittdarstellung einer Anordnung mit einem Anschlussstecker 7, welcher durch eine Öffnung 4 in einer Gehäuseseitenwand 3 in das Gehäuse 1 eingeführt ist.

Insbesondere ist der Anschlussstecker 7 mit dem Stromversorgungsanschluss 6 im Gehäuseinneren des Gehäuses 1 konnektiert, wobei der Stromversorgungsanschluss 6 auf einem Systemboard 9 montiert ist.

Durch den Anschlussstecker 7 wurden die Riegel 5a und 5b gemäß der oben erläuterten Art über Anlaufschrägen an den ersten Enden 15a und 15b von einer ersten Position (siehe Figur 1) in die in Figur 3 dargestellte zweite Position bewegt (siehe auch Figur 2). Gemäß Figur 3 tauchen die zweiten Enden 25a und 25b der Riegel 5a und 5b jeweils durch Durchbrüche 18a und 18b in Abdeckblechen 8a und 8b des Gehäuses 1. Weiterhin tauchen die zweiten Enden 25a und 25b in Nuten 12a und 12b von Gehäuseverkleidungen 2a und 2b des Gehäuses 1.

Gemäß der Ausführung in Figur 3 erfüllen die Riegel 5a und 5b somit eine doppelte Verriegelungsfunktion. Eine erste Verriegelung ist dadurch gegeben, dass die Enden 25a und 25b durch die Abdeckbleche 8a und 8b hindurchtauchen. Die Abdeckbleche 8a und 8b dienen zum Verschließen des Gehäuseinnenraums und können beispielsweise an der Gehäuseseitenwand 3 stabil verschraubt werden. Auf diese Weise ist das Gehäuse 1 durch die Abdeckbleche 8a und 8b vor Zugang in den Gehäuseinnenraum geschützt.

Eine weitere Verriegelungsfunktion ergibt sich durch Eintauchen der zweiten Enden 25a und 25b in die Nuten 12a und 12b der äußeren Gehäuseverkleidungen 2a und 2b. Die Gehäuseverkleidungen 2a und 2b dienen beispielsweise der ästhetischen Verkleidung des Gehäuses 1 nach außen und bilden beispielsweise Designdeckel aus Kunststoff. Die Gehäuseverkleidungen 2a und 2b können daneben jedoch auch Sicherheitsaufgaben einer Gehäuseabdeckung und eines Gehäuseverschlusses nach außen hin erfüllen.

Durch die in Figur 3 dargestellte Verriegelung sowohl der Abdeckbleche 8a und 8b als auch der Gehäuseverkleidungen 2a und 2b können diese nicht geöffnet beziehungsweise abgenommen werden. Das Gehäuse 1 ist somit in der in Figur 3 dargestellten Form derart verriegelt, dass die Gehäusewandungen 2a und 2b sowie 8a und 8b nicht eröffnet werden können. Ein Zugang in den Gehäuseinnenraum ist somit bei gestecktem Anschlussstecker 7 nicht möglich. Insbesondere bei einer Versorgung von elektronischen Komponenten, wie zum Beispiel des Systemboards 9, im Inneren des Gehäuses 1 mit einer Wechselspannung des Stromversorgungsnetzes über den Anschlussstecker 7 ist auf diese Weise der Zugang zu stromführenden Komponenten im Gehäuseinnenraum verhindert.

Erst wenn der Anschlussstecker 7 nach außen abgezogen wird und eine elektrische Verbindung zum Stromversorgungsanschluss 6 aufgetrennt wird, werden die Riegel 5a und 5b, beispielsweise unter Zuhilfenahme von flexiblen Elementen (nicht dargestellt), wieder in eine Ursprungsposition (siehe Figur 1) zurück bewegt, sodass die Verriegelung der Gehäuseverkleidungen 2a und 2b beziehungsweise der Abdeckbleche 8a und 8b aufgehoben wird. Die Gehäuseverkleidungen 2a und 2b können dann beispielsweise horizontal verschoben und vom Gehäuse 1 abgenommen werden. Die Abdeckbleche 8a und 8b können von der Gehäuseseitenwand 3 gelöst und beispielsweise nach oben hin beziehungsweise nach unten hin abgenommen werden, sodass der Gehäuseinnenraum eröffnet ist.

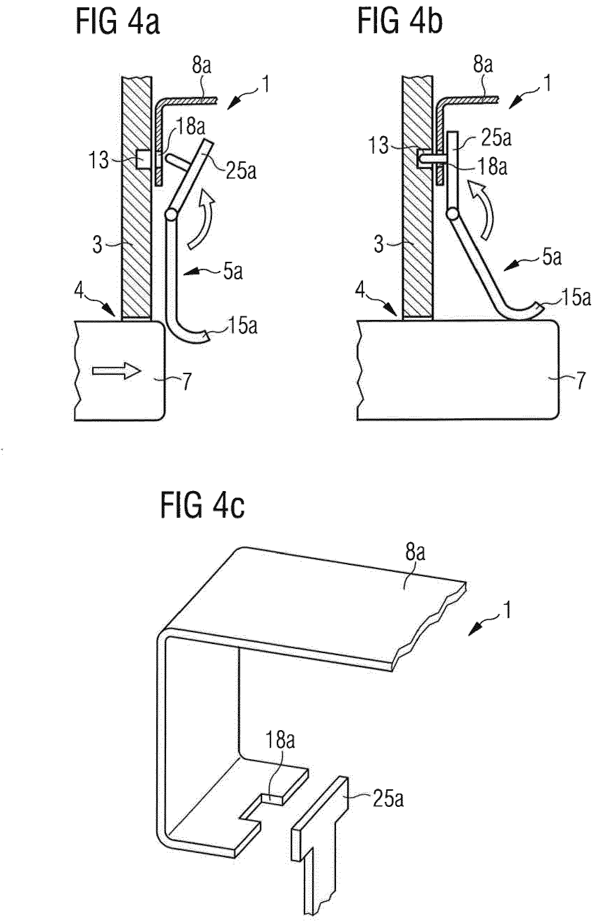

Figur 4A zeigt beispielhaft eine weitere Ausführungsform einer Verriegelung eines Abdeckblechs 8a am Gehäuse 1 über eine Verriegelungsvorrichtung, welche ebenfalls einen Riegel 5a umfasst. Im Unterschied zu den vorangegangenen Ausführungsformen ist der Riegel 5a in der Ausführungsform gemäß Figur 4A jedoch nicht translatorisch, sondern rotatorisch bewegbar. Das bedeutet, dass der Riegel 5a um eine vorbestimmte Drehachse schwenkbar ist. Der Riegel 5a weist ein erstes Ende 15a mit einer Anlaufschräge und ein zweites Ende 25a mit einem Verriegelungsstift oder -zapfen auf. Der Verriegelungsstift ist eingerichtet, um durch einen Durchbruch 18a am Abdeckblech 8a hindurch in eine Nut 13 in der Gehäuseseitenwand 3 einzutauchen und das Abdeckblech 8a auf diese Weise zu verriegeln.

Ähnlich wie in den Ausführungsformen der Figuren 1 bis 3 ist auch in Figur 4A der Riegel 5a über einen Anschlussstecker 7 bedienbar, welcher in die Öffnung 4 an der Gehäuseseitenwand 3 einführbar ist. Gemäß Figur 4A ist der Anschlussstecker 7 nur teilweise in das Gehäuse 1 eingeführt und wirkt noch nicht mit dem Riegel 5a zusammen. Somit ist der Riegel 5a, gegebenenfalls unter Zuhilfenahme eines flexiblen Elements (nicht dargestellt) in einer ersten Position gehalten. In dieser ersten Position kann das Abdeckblech 8a noch frei am Gehäuse 1 bewegt und ausgerichtet werden.

In Figur 4B ist der Anschlussstecker 7 vollständig in das Gehäuse 1 eingeführt, wobei der Riegel 5a am ersten Ende 15a über die Anlaufschräge derart bedient wurde, dass der Riegel 5a in eine zweite Position verschwenkt ist. In der zweiten Position taucht das zweite Ende 25a des Riegels 5a mit dem Verriegelungsstift durch den Durchbruch 18a am Abdeckblech 8a und in die Nut 13 der Gehäuseseitenwand 3 ein. Auf diese Weise ist das Abdeckblech 8a verriegelt und kann nicht mehr vom Gehäuse 1 abgenommen werden. Figur 4B repräsentiert einen Zustand, in dem der Anschlussstecker 7 elektrisch mit einem Stromversorgungsanschluss im Gehäuseinnenraum zusammenwirkt (siehe Figur 3).

Eine weitere alternative Ausführungsform einer Verriegelung eines Abdeckblechs 8a des Gehäuses 1 ist in Figur 4C schematisiert dargestellt. Hierbei wird eine Verriegelung dadurch erzeugt, dass ein erstes Ende 25a eines Riegels 5a (siehe Figuren 4A und 4B) hakenförmig ausgebildet ist und in eine Nut beziehungsweise einen Durchbruch 18a am Abdeckblech 8a eingreifen kann. Auch auf diese Weise kann das Abdeckblech 8a beispielhaft gemäß der in Figur 4A und 4B dargestellten Wirkweise verriegelt werden.

Eine Verriegelungsvorrichtung der erläuterten Art hat den Vorteil, dass ein Gehäuse eines Computersystems erst dann geöffnet werden kann, wenn ein elektrischer Anschlussstecker nach außen abgezogen wird. Auf diese Weise wird verhindert, dass elektrische Energie elektronischen Komponenten im Gehäuseinnenraum zugeführt wird, wenn das Gehäuse geöffnet ist. Somit wird die Gefahr eines elektrischen Schlags erheblich reduziert beziehungsweise unterbunden.

In nicht dargestellten Ausführungsformen ist es denkbar, eine Verriegelungsvorrichtung derart auszuführen, dass sie alternativ durch unterschiedliche Anschlussstecker bedienbar ist. Dabei ist denkbar, dass die Verriegelungsvorrichtung automatisch das Gehäuse verriegelt, wenn wenigstens einer der mehreren Anschlussstecker gesteckt ist und erst dann das Gehäuse freigibt, wenn sämtliche Anschlussstecker abgezogen sind.

### Bezugszeichenliste

- 1: Gehäuse
- 2a, 2b: Gehäuseverkleidung
- 3: Gehäuseseitenwand
- 4: Öffnung für externen Anschlussstecker
- 5a, 5b: Riegel
- 6: Stromversorgungsanschluss
- 7: Anschlussstecker
- 8a, 8b: Abdeckblech
- 9: Systemboard
- 12a, 12b: Nut in Gehäuseverkleidung
- 13: Nut in Gehäuseseitenwand
- 15a, 15b: erstes Ende des Riegels
- 18a, 18b: Durchbruch im Abdeckblech
- 25a, 25b: zweites Ende des Riegels

## Patentansprüche

1. Gehäuse (1) für ein Computersystem, wobei das Gehäuse (1) zumindest an einer ersten Gehäusewandung (2a, 2b, 8a, 8b) zum Zugang in das Gehäuse (1) geöffnet werden kann und an einer zweiten Gehäusewandung (3) eine Öffnung (4) für einen externen Anschlussstecker (7) angeordnet ist und wobei das Gehäuse (1) eine Verriegelungsvorrichtung zum Verriegeln der ersten Gehäusewandung (2a, 2b, 8a, 8b) gegen ein Öffnen des Gehäuses (1) aufweist, wobei die Verriegelungsvorrichtung an der Öffnung (4) für einen externen Anschlussstecker (7) angeordnet und über einen externen Anschlussstecker (7) derart bedienbar ist, dass die erste Gehäusewandung (2a, 2b, 8a, 8b) verriegelt ist, wenn ein externer Anschlussstecker (7) in die Öffnung (4) eingeführt ist, und die erste Gehäusewandung (2a, 2b, 8a, 8b) entriegelt ist, wenn kein externer Anschlussstecker (7) in die Öffnung (4) eingeführt ist,
**dadurch gekennzeichnet, dass**
die Verriegelungsvorrichtung zumindest einen Riegel (5a, 5b) umfasst, welcher zwischen einer ersten Position und einer zweiten Position bewegbar ist, wobei der Riegel (5a, 5b) in der ersten Position außer Eingriff mit der ersten Gehäusewandung (2a, 2b, 8a, 8b) ist und in der zweiten Position in Eingriff mit der ersten Gehäusewandung (2a, 2b, 8a, 8b) ist.

2. Gehäuse (1) nach Anspruch 1, wobei der Riegel (5a, 5b) über ein flexibles Element gefedert gelagert ist, wobei der Riegel (5a, 5b) bei Entspannung des flexiblen Elements in der ersten Position ist und entgegen einer Kraft des flexiblen Elements von der ersten Position in die zweite Position bringbar ist.

3. Gehäuse (1) nach Anspruch 1 oder 2, wobei der Riegel (5a, 5b) in der ersten Position mit einem ersten Ende (15a, 15b) in die Öffnung (4) für einen externen Anschlussstecker (7) hineinragt und bei Kontakt mit einem externen Anschlussstecker (7) in die zweite Position gedrückt werden kann.

4. Gehäuse (1) nach Anspruch 3, wobei das erste Ende (15a, 15b) des Riegels (5a, 5b) eine Anlaufschräge zum mechanischen Zusammenwirken mit einem externen Anschlussstecker (7) aufweist.

5. Gehäuse (1) nach Anspruch 4, wobei die Bewegungsrichtung des Riegels (5a, 5b) von der ersten Position in die zweite Position eine Drehbewegung ist oder linear schräg ist zur Bewegungsrichtung eines externen Anschlusssteckers (7), der in die Öffnung (4) eingeführt wird.

6. Gehäuse (1) nach einem der Ansprüche 1 bis 5, wobei die erste Gehäusewandung (2a, 2b, 8a, 8b) zum Öffnen des Gehäuses (1) gegenüber dem Gehäuse (1) schwenkbar oder vollständig vom Gehäuse (1) abnehmbar ist.

7. Computersystem mit einem Gehäuse (1) nach einem der Ansprüche 1 bis 6, wobei im Gehäuse (1) zumindest ein Systemboard (9) sowie hinter der Öffnung (4) an der zweiten Gehäusewandung (3) ein Stromversorgungsanschluss (6) zum elektrischen Zusammenwirken mit einem externen Anschlussstecker (7) angeordnet ist.

8. Computersystem nach Anspruch 7, wobei in die Öffnung (4) an der zweiten Gehäusewandung (3) ein externer Anschlussstecker (7) eingeführt ist und die erste Gehäusewandung (2a, 2b, 8a, 8b) verriegelt ist.

9. Computersystem nach Anspruch 7 oder 8, wobei das Computersystem ein Thin Client, All-in-One-PC oder Mini-PC ist.

## Claims

1. A housing (1) for a computer system, wherein the housing (1) can be opened at least at a first housing wall (2a, 2b, 8a, 8b) for access into the housing (1), and an opening (4) for an external connecting plug (7) is disposed at a second housing wall (3), and wherein the housing (1) has a locking device to lock the first housing wall (2a, 2b, 8a, 8b) against an opening of the housing (1), wherein the locking device is disposed at the opening (4) for an external connecting plug (7) and is actuatable via an external connecting plug (7) in such a way that the first housing wall (2a, 2b, 8a, 8b) is locked when an external connecting plug (7) is inserted into the opening (4), and the first housing wall (2a, 2b, 8a, 8b) is unlocked if no external connecting plug (7) is inserted into the opening (4),
**characterized in that**
the locking device comprises at least one bolt (5a, 5b) which is movable between a first position and a second position, wherein the bolt (5a, 5b) is out of engagement with the first housing wall (2a, 2b, 8a, 8b) in the first position, and is in engagement with the first housing wall (2a, 2b, 8a, 8b) in the second position.

2. Housing (1) according to claim 1,
wherein the bolt (5a, 5b) is spring-mounted via a flexible element, wherein the bolt (5a, 5b) is in the first position when the flexible element is not under tension and can be brought from the first position into the second position against a force of the flexible element.

3. Housing (1) according to claim 1 or 2,
wherein in the first position the bolt (5a, 5b) projects with a first end (15a, 15b) into the opening (4) for an external connecting plug (7) and can be pressed into the second position upon contact with an external connecting plug (7).

4. Housing (1) according to claim 3,
wherein the first end (15a, 15b) of the bolt (5a, 5b) comprises an angled face for mechanical interaction with an external connecting plug (7).

5. Housing (1) according to claim 4,
wherein the direction of motion of the bolt (5a, 5b) from the first position into the second position is a rotary motion or linearly inclined to the direction of motion of an external connecting plug (7) being inserted into the opening (4).

6. Housing (1) according to one of claims 1 to 5,
wherein
to open the housing (1), the first housing wall (2a, 2b, 8a, 8b) is swivel-mounted with respect to the housing (1) or can be completely removed from the housing (1).

7. Computer system with a housing (1) according to one of claims 1 to 6, wherein at least a system board (9) and, behind the opening (4) at the second housing wall (3), a power supply connector (6) for electric interaction with an external connecting plug (7) is arranged in the housing (1).

8. Computer system according to claim 7, wherein an external connecting plug (7) is inserted into the opening (4) at the second housing wall (3) and the first housing wall (2a, 2b, 8a, 8b) is locked.

9. Computer system according to claim 7 or 8, wherein the computer system is a thin client, an all-in-one PC or a mini PC.

## Revendications

1. Boîtier (1) pour un système informatique, le boîtier (1) pouvant être ouvert au moins sur une première paroi de boîtier (2a, 2b, 8a, 8b) pour l'accès au boîtier (1) et une ouverture (4) pour une fiche de raccordement externe (7) étant disposée sur une deuxième paroi de boîtier (3), et le boîtier (1) présentant un dispositif de verrouillage destiné à verrouiller la première paroi de boîtier (2a, 2b, 8a, 8b) pour empêcher une ouverture du boîtier (1), le dispositif de verrouillage étant disposé sur l'ouverture (4) pour une fiche de raccordement externe(7) et pouvant être operable par l'intermédiaire d'une fiche de raccordement externe (7) de manière à ce que la première paroi de boîtier (2a, 2b, 8a, 8b) soit verrouillée lorsqu'une fiche de raccordement externe (7) est introduite dans l'ouverture (4), et que la première paroi de boîtier (2a, 2b, 8a, 8b) soit déverrouillée lorsqu'aucune fiche de raccordement externe (7) n'est introduite dans l'ouverture (4),
**caractérisé en ce que**
le dispositif de verrouillage comprend au moins un verrou (5a, 5b) qui est déplaçable entre une première position et une deuxième position, le verrou (5a, 5b) étant désengagé de la première paroi de boîtier (2a, 2b, 8a, 8b) dans la première position et étant en prise avec la première paroi de boîtier (2a, 2b, 8a, 8b) dans la deuxième position.

2. Boîtier (1) selon la revendication 1,
le verrou (5a, 5b) étant logé de manière élastique par l'intermédiaire d'un élément flexible, le verrou (5a, 5b), lorsque l'élément flexible est détendu, étant dans la première position et pouvant être mis de la première position en la deuxième position contre une force de l'élément flexible.

3. Boîtier (1) selon la revendication 1 ou 2,
le verrou (5a, 5b), dans la première position, faisant saillie, dans l'ouverture (4) pour une fiche de raccordement externe (7), avec une première extrémité (15a, 15b), et, en cas de contact avec une fiche de raccordement externe (7) pouvant être poussé dans la deuxième position.

4. Boîtier (1) selon la revendication 3,
la première extrémité (15a, 15b) du verrou (5a, 5b) présentant un chanfrein d'attaque pour l'interaction mécanique avec une fiche de raccordement externe (7).

5. Boîtier (1) selon la revendication 4,
la direction de déplacement du verrou (5a, 5b) de la première position en la deuxième position étant un mouvement rotatif ou étant linéairement oblique par rapport à la direction de déplacement d'une fiche de raccordement externe (7) qui est introduite dans l'ouverture (4).

6. Boîtier (1) selon l'une quelconque des revendications 1 à 5,
la première paroi de boîtier (2a, 2b, 8a, 8b) étant pivotante par rapport au boîtier (1) pour l'ouverture du boîtier (1) ou étant complètement amovible du boîtier (1) .

7. Système informatique comprenant un boîtier (1) selon l'une quelconque des revendications 1 à 6, au moins une carte mère (9) ainsi qu'un raccord d'alimentation en courant (6), derrière l'ouverture (4) ménagée sur la deuxième paroi de boîtier (3), pour l'interaction électrique avec une fiche de raccordement externe (7) étant disposés.

8. Système informatique selon la revendication 7, une fiche de raccordement externe (7) étant introduite dans l'ouverture (4) sur la deuxième paroi de boîtier (3) et la première paroi de boîtier (2a, 2b, 8a, 8b) étant verrouillée.

9. Système informatique selon la revendication 7, le système informatique étant un Thin Client, un PC All-In-One ou un mini PC.
